# EUROPEAN PATENT SPECIFICATION

(11) **EP 2 482 033 B1**
(45) Date of publication and mention of the grant of the patent: **21.10.2015**
(21) Application number: 10818790.7
(22) Date of filing: 22.09.2010
(51) Int. Cl.: G01C 17/38, G01R 33/02

(54) **GEOMAGNETISM DETECTION DEVICE**
VORRICHTUNG ZUR GEOMAGNETISMUSERKENNUNG
DISPOSITIF DE DÉTECTION DE GÉOMAGNÉTISME

(30) Priority: 26.09.2009 JP 2009221715
(43) Date of publication of application: 01.08.2012
(73) Proprietor: Alps Electric Co., Ltd., Tokyo 145-8501 (JP)
(72) Inventor: HIROBE, Kisei, Tokyo 145-8501 (JP); YAMADA, Yukimitsu, Tokyo 145-8501 (JP)
(74) Representative: Wohlfrom, Karl-Heinz
(86) International application number: PCT/JP2010/066344
(87) International publication number: WO 2011/037117

(56) References cited:
- EP-A2- 1 775 550
- EP-A2- 1 821 067
- WO-A1-2008/146757
- JP-A- 5 196 468
- JP-A- 2006 226 810
- US-A1- 2002 035 791

## Description

### Technical Field

The present invention relates to a geomagnetic sensing device including correcting means for the case where an offset error is generated after calibration.

### Background Art

In geomagnetic sensing devices, due to the influence of magnetization and the like of peripheral components, an offset as well as a geomagnetic quantity is added to an output of a magnetic sensor. Thus, in the case of measuring the angular velocity, azimuth, etc. using a geomagnetic gyro, calibration for obtaining a reference point (the origin of a geomagnetic vector) of an output of a magnetic sensor is first performed, and offset correction is performed in accordance with the calibration (see Patent Literature mentioned below).

However, there is a problem in that after calibration, the influence of external environment (for example, the influence of temperature or the influence of a surrounding magnetic field) causes an error in the offset mentioned above.

In the inventions described in the Patent Literature mentioned below, means for, in the case where an offset error is generated after calibration as described above, correcting the offset error is not mentioned.

Furthermore, there is a problem in that, when an offset error is generated, high-accuracy measurement of angular velocity and azimuth cannot be stably achieved or sensing errors may occur.

### Citation List

### Patent Literature

PTL 1: International Publication WO2007/129653
PTL 2: Japanese Unexamined Patent Application Publication No. 2007-107921
PTL 3: Japanese Unexamined Patent Application Publication No. 2007-139715

US 2002 035 791 A1 describes a compass system which utilizes an improved calibration routine in which a processing circuit of the compass recalibrates the compass each time three data points are obtained from a magnetic field sensor that meet predetermined criteria. One such criterion is that the three data points define corners of a triangle that is substantially non-obtuse. When three data points have been obtained that define a triangle meeting this criterion, the processing circuit calculates a center point for a circle upon which all three data points lie by solving the equation using the coordinate values for the three data points and defining the center point.

According to EP 1 821 067 A2 magnetic-sensor controller includes an input section, a perpendicular-bisector calculation section, a storage section, and a setting section. The input section successively inputs a plurality of magnetic data sets successively output from a three-dimensional magnetic sensor. Each magnetic data includes three components. The perpendicular-bisector calculation section calculates, for each pair of two of the magnetic data sets, a perpendicular bisector of two points corresponding to the two magnetic data sets. The storage section stores a plurality of perpendicular bisectors. The setting section statistically approximates, by a single point, a region where the plurality of perpendicular bisectors stored in the storage section meet, and sets an offset of the magnetic data set on the basis of the single point. The magnetic-sensor controller enables accurate setting of an offset even when the magnetic field strength changes.

According EP 1 775 550 A2 a magnetic sensor control device has an input unit, a selection unit, a calculation unit, and a setting unit. The input unit inputs a plurality of magnetic data each having components sequentially output from a 3-dimensional magnetic sensor. The selection unit selects magnetic data satisfying a predetermined 4-point selection condition from the plurality of the input magnetic data. The calculation unit calculates a center point equally distant from four points corresponding to the four selected magnetic data. The setting unit sets three components representing the center point as an offset of the magnetic data.

### Summary of Invention

### Technical Problem

The present invention solves the existing problems mentioned above, and an object of the present invention is to provide a geomagnetic sensing device including correcting means capable of correcting an offset error generated after calibration.

### Solution to Problem

A geomagnetic sensing device according to the present invention is defined by claim 1. An exemplary embodiment includes a magnetic sensor having two or more axes; and a controller including calibration means for obtaining a reference point of an output of the magnetic sensor and correcting means for correcting an offset error.

The correcting means includes an extraction step of extracting a plurality of output coordinate points that are deviated from an outer edge of a virtual circle or an outer edge of a virtual sphere having a radius R defined by the magnitude of a geomagnetic vector centered at the reference point and that are located at coordinate positions different from each other, a first step of marking a coordinate position that is on a virtual straight line extending from a first output coordinate point and passing through the reference point and that is moved from the first output coordinate point toward the reference point by a distance corresponding to the radius R, a second step of newly marking a coordinate position that is moved on a virtual straight line extending from a second output coordinate point and passing through the marked position obtained in the first step from the second output coordinate point toward the marked position by the distance corresponding to the radius R, and a third step of repeatedly performing the second step for sequentially updating the most recently set marked position to a new marked position alternately between the individual output coordinate points in order and setting a convergent point of the marks as a new reference point of an output of the magnetic sensor.

According to the present invention, even in the case where an offset error is generated after calibration, the offset error can be appropriately corrected. In particular, in the invention mentioned above, a minor offset error can be appropriately coped with. Furthermore, operation processing can be performed using the radius R (the magnitude of a geomagnetic vector) of the virtual circle or the virtual sphere, and the offset error can be corrected appropriately and easily with a small amount of operation. Thus, the burthen to the controller can be reduced.

The present invention is preferably applicable to a configuration in which the magnetic sensor has three axes, and in the extraction step, at least three output coordinate points that are deviated from the outer edge of the virtual sphere having the radius R centered at the reference point and that are located at coordinate positions different from each other are extracted, or the magnetic sensor has two axes, and in the extraction step, at least two output coordinate points that are deviated from the outer edge of the virtual circle having the radius R centered at the reference point and that are located at coordinate positions different from each other are extracted, and the first to third steps are performed.

In addition, in the present invention, preferably, in a case where an output coordinate point is deviated further outward than the outer edge of the virtual circle or the virtual sphere having the radius R centered at the reference point and is located at a coordinate position that is distant from the reference point by a specific number of times or more the length of the radius R, the correcting means includes, prior to the extraction step, a first correction step of drawing a virtual straight line between the coordinate point and the reference point and setting a coordinate position that is moved from the output coordinate point toward the reference point by the distance corresponding to the radius R as a new reference point.

In the case where a major offset error is generated, the offset error is dynamically corrected by first performing the first correction step, without performing the extraction step and the first to third steps. In the dynamic correction of an offset error, operation processing can be performed using the radius R (the magnitude of a geomagnetic vector) of a virtual circle or a virtual sphere, and the offset error can be corrected easily with a small amount of operation. Thus, the burden to the controller can be reduced.

### Advantageous Effects of Invention

According to the present invention, even in the case where an offset error is generated after calibration, the offset error can be appropriately corrected.

### Brief Description of Drawings

[Fig. 1] Fig. 1 is a circuit block diagram of a geomagnetic sensing device according to an embodiment of the present invention.
[Fig. 2] Fig. 2 is an explanatory diagram of an X-axis magnetic sensor, a Y-axis magnetic sensor, and a Z-axis magnetic sensor provided in a sensor portion.
[Fig. 3] Fig. 3 is a schematic diagram of a reference point Og of an output obtained by a calibration process and a virtual sphere with a radius R centered at the reference point Og.
[Fig. 4] Fig. 4 is a schematic diagram for explaining a step for performing a first offset error correction (dynamic correction).
[Fig. 5] Fig. 5 is a schematic diagram for explaining a step for performing a second offset error correction.
[Fig. 6] Fig. 6 is a flowchart for explaining an operation by an offset error correcting unit of a controller.
[Fig. 7] Fig. 7 is a flowchart of the step for performing the second offset error correction.

### Description of Embodiments

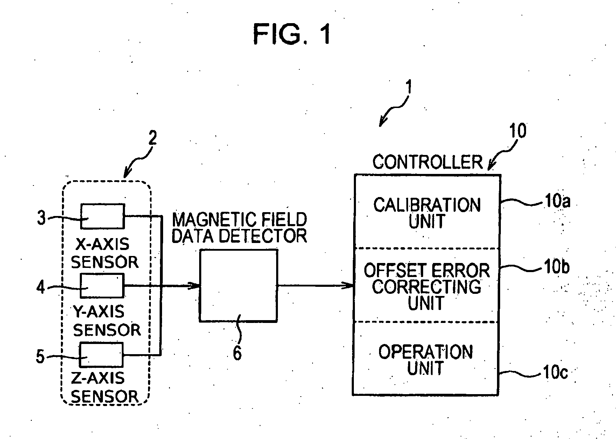

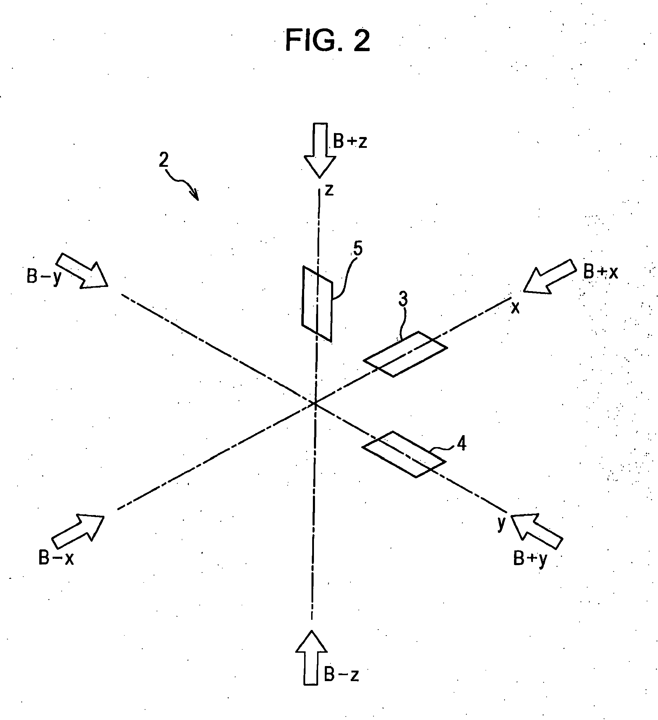

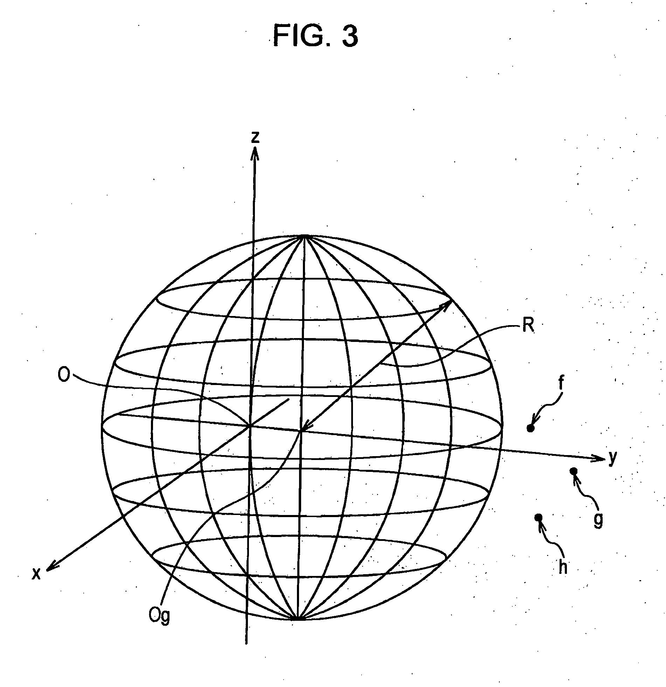

Fig. 1 is a circuit block diagram of a geomagnetic sensing device according to an embodiment of the present invention. Fig. 2 is an explanatory diagram of an X-axis magnetic sensor, a Y-axis magnetic sensor, and a Z-axis magnetic sensor provided in a sensor portion. Fig. 3 is a schematic diagram of a reference point Og of an output obtained by a calibration process and a virtual sphere with a radius R centered at the reference point Og.

A magnetic sensor 2 provided in a geomagnetic sensing device 1 according to an embodiment of the present invention illustrated in Fig. 1 has a configuration supporting three axes. That is, the magnetic sensor 2 is configured to include an X-axis magnetic sensor 3, a Y-axis magnetic sensor 4, and a Z-axis magnetic sensor 5.

In the embodiment illustrated in Figs. 1 and 2, the X-axis magnetic sensor 3, the Y-axis magnetic sensor 4, and the Z-axis magnetic sensor 5 are each include a GMR element, an AMR element, a Hall element, etc.

The X-axis magnetic sensor 3 detects a component Bx, which directs in a geomagnetic reference X-direction, and is capable of detecting a magnetic field component B+x, which is in the positive direction in the reference X-direction, and a magnetic field component B-x, which is in the negative direction in the reference X-direction.

The Y-axis magnetic sensor 4 detects a component By, which directs in a geomagnetic reference Y-direction, and is capable of detecting a magnetic field component B+y, which is in the positive direction in the reference Y-direction, and a magnetic field component B-y, which is in the negative direction in the reference Y-direction.

The Z-axis magnetic sensor 5 detects a component Bz, which directs in a geomagnetic reference Y-direction, and is capable of detecting a magnetic field component B+z, which is in the positive direction in the reference Z-direction, and a magnetic field component B-z, which is in the negative direction in the reference Z-direction.

A magnetic field data detector 6 illustrated in Fig. 1 includes an electric circuit in which the sensors 3, 4, and 5 are connected in series with fixed resistors. The midpoint voltage between the X-axis magnetic sensor 3 and the fixed resistor, the midpoint voltage between the Y-axis magnetic sensor 4 and the fixed resistor, and the midpoint voltage between the Z-axis magnetic sensor 5 and the fixed resistor can be extracted as a detection output in the X-axis, a detection output in the Y-axis, and a detection output in the Z-axis, respectively.

As illustrated in Fig. 1, the detection outputs in the X-axis, Y-axis, and Z-axis detected by the magnetic field data detector 6 are supplied to a controller 10. The controller 10 is configured to include a calibration unit 10a, an offset error correcting unit lOb, an operation unit 10c, and the like. The operation unit 10c includes an angular velocity operation part, an angular acceleration operation part, an azimuth operation part, and the like. The calibration unit 10a, the offset error correcting unit 10b, and the operation unit 10c are each implemented by programmed software.

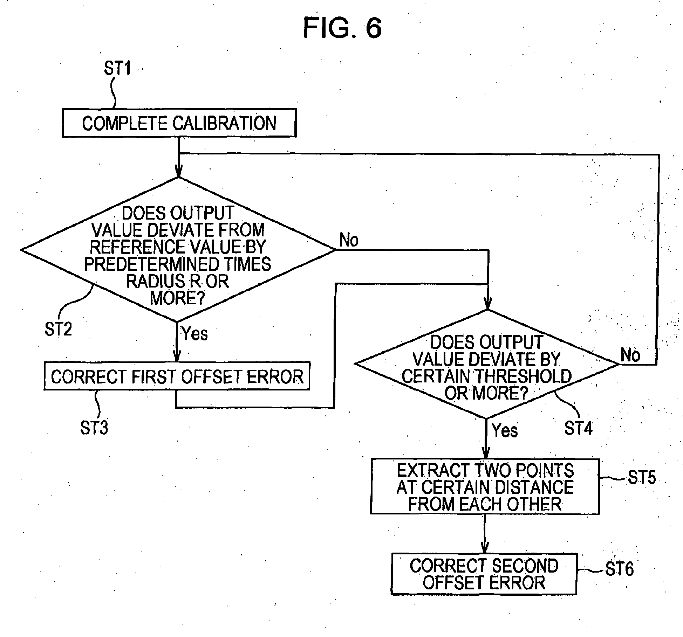

Hereinafter, the operation of the controller 10 will be explained. In this embodiment, as illustrated in Fig. 6, the calibration unit 10a performs a calibration process (offset correction) as step ST1.

Namely, in the geomagnetic sensing device 1, due to the influence of magnetization and the like of peripheral components, an offset as well as a geomagnetic quantity is added to an output of the magnetic sensor. Thus, it is necessary that calibration for obtaining a reference point (the origin of a geomagnetic vector) of an output of the magnetic sensor should be first performed and offset correction should be performed in accordance with the calibration.

The geomagnetic sensing device 1 according to the invention is moved at random to detect a large number of coordinate points of outputs of the magnetic sensor 2 in a three-dimensional space (here, an output means an output obtained by the magnetic field data detector 6, and the same applies to the following cases), and the calibration unit 10a calculates the center of a virtual sphere, which is obtained from these coordinate points. Then, as illustrated in Fig. 3, the center of the virtual sphere is set as a reference point (the origin of a geomagnetic vector) of an output. As illustrated in Fig. 3, the virtual sphere is a spherical body with a radius R centered at the reference point Og. The radius R represents the magnitude of a geomagnetic vector. As illustrated in Fig. 3, the reference point Og is located at a position that is deviated from the intersection O of the reference X-direction, the reference Y-direction, and the reference Z-direction. The amount of difference between the reference point Og and the intersection O is defined as an offset.

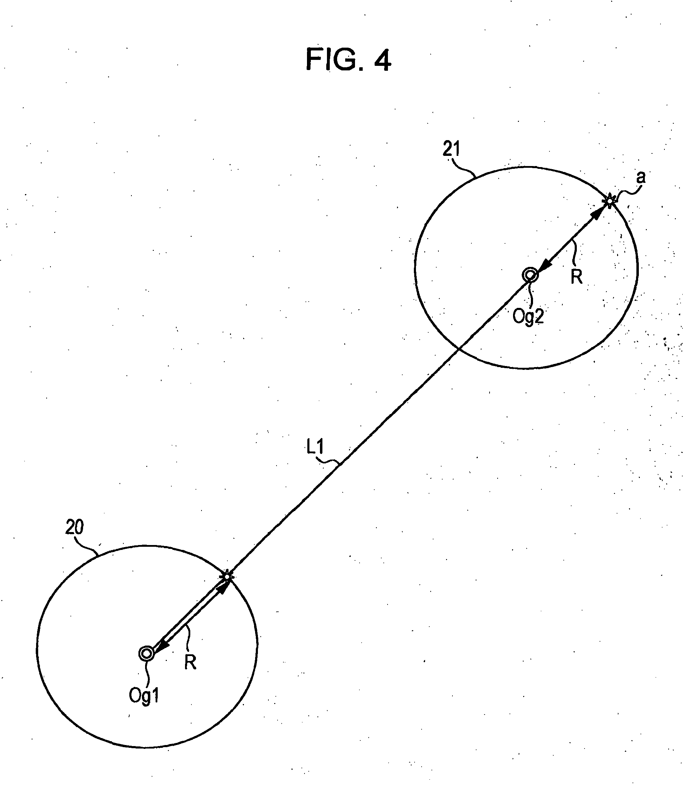

In this embodiment, the magnetic sensor 2 composed of the three axes in Fig. 1 is capable of obtaining the virtual sphere centered at the reference point Og of an output illustrated in Fig. 3 by calibration. However, in the case where, for example, a magnetic sensor is composed of two axes, the X-axis magnetic sensor 3 and the Y-axis magnetic sensor 4, a virtual circle 20 with a radius R centered at a reference point Og1 of an output of the magnetic sensor can be obtained on the X-Y coordinate plane by calibration, as illustrated in Fig. 4. Hereinafter, correction of an offset error will be explained. For an easier explanation, the explanation will be given in a two-dimensional manner.

After step ST1 of the calibration process illustrated in Fig. 6 is completed, an error may be generated in the offset due to the influence of temperature or the influence of a surrounding magnetic field. In such a case, in this embodiment, the offset error can be corrected by the offset error correcting unit 10b.

First, in step ST2 in Fig. 6, if, as illustrated in Fig. 4, the currently obtained coordinate point a of an output of the magnetic sensor is located at a coordinate position that is deviated further outward than the outer edge of the virtual circle 20 and the coordinate point a is distant from the reference point Og1 by a specific number of times or more (more specifically, twice or more, and for example, defined as three times) the length of the radius R, the process proceeds to the next step for performing a first offset error correction (first correction step ST3).

In the first correction step ST3, as illustrated in Fig. 4, a virtual straight line L1 is drawn between the output coordinate point a and the reference point Og1, and the coordinate position that is moved from the coordinate point a toward the reference point Og1 by the distance corresponding to the radius R is reset as a new reference point Og2.

In the first correction step ST3, for example, in the case where, after calibration is completed, the geomagnetic sensing device 1 is placed under the circumstances having a strong magnetic field and a major offset error is generated, the offset error can be dynamically corrected in the first correction step ST3.

As illustrated in Fig. 6, in the case where the obtained output coordinate point is not distant from the reference point Og1 by a specific number of times or more the length of the radius R, the process does not proceed to the first correction step ST3. That is, in the case where a major offset error is not generated, although the process does not proceed to the first correction step ST3, a minor offset error may be generated. In addition, even if an offset error is dynamically corrected as illustrated in Fig. 4, a minor offset error may be generated when viewed from the new reference point Og2. Although depending on the use or a required accuracy, in the case where it is determined in step ST4 that this minor offset error is not too small to be neglected, the process proceeds to extraction step ST5 and a second offset error correction (second correction step ST6).

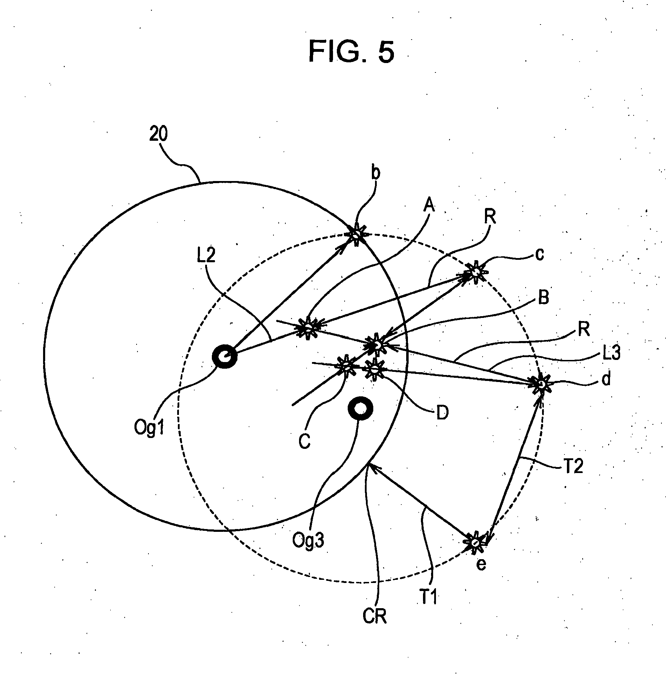

In step ST4 illustrated in Fig. 6, the offset error correcting unit 10b determines whether or not an output value of the magnetic sensor is deviated by a certain threshold or more. As illustrated in Fig. 5, among a plurality of output values (output coordinate points) b, c, d, and e obtained from the magnetic sensor, the output coordinate points c, d, and e are located at coordinate positions that are deviated further outward than the outer edge of the virtual circle 20 (the virtual circle 21 in the case where change to the reference point Og2 illustrated in Fig. 4 has been made in the first correction step ST3) and the coordinate positions differ from each other.

Among these output coordinate points, the output coordinate point e is deviated from an intersection CR, at which a line drawn between the output coordinate point e and the reference point Og1 and the virtual circle 20 intersect, by an error amount T1 or more. This state is set as, for example, the state "being deviated by a certain threshold or more" described above.

By setting the error amount T1 to be smaller, a much smaller offset error can be corrected. However, the error amount T1 can be set in a desirable manner while taking into consideration the use, a required accuracy, the burden to the controller 10, and the like.

As illustrated in Fig. 6, when the determination in step ST4 is "Yes", the process proceeds to the extraction step ST5, in which two output coordinate points that are distant by a certain distance are extracted. In step ST5, at least two points are extracted. This is for the case where an offset error is corrected on a two-dimensional coordinate, as illustrated in Fig. 5. For the case where an offset error is corrected in a three-dimensional space as illustrated in Fig. 3, it is necessary to extract at least three points (coordinate points f, g, and h in Fig. 3).

Here, the output coordinate points c and d, which are distant from the output coordinate point e by a distance T2 or more, are certified as the "two points distant by a certain distance" described above. The output coordinate point c is defined as a first output coordinate point c and the output coordinate point d is defined as a second output coordinate point d. Then, the process proceeds to the second correction step ST6 illustrated in Fig. 6. Here, the first output coordinate point c and the second output coordinate point d are located at coordinate positions different from each other, and the output coordinate points c and d are distant from each other by a predetermined distance or more.

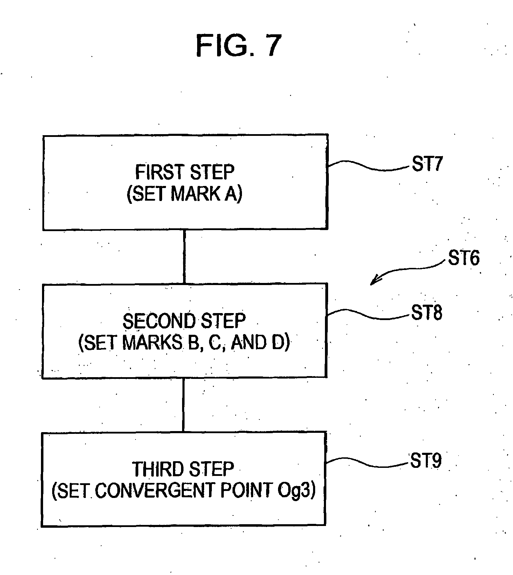

Next, the second correction step ST6 will be explained in detail with reference to Figs. 5 and 7. In the second correction step ST6, first, as first step ST7, a virtual straight line L2 extending from the first output coordinate point c and passing through the reference point Og1 is drawn on the coordinate plane. Then, a coordinate position that is on the virtual straight line L2 and that is moved from the first output coordinate point c toward the reference point Og1 by the distance corresponding to the radius R is marked (set a marked position A).

Then, as second step ST8 in the second correction step ST6, a virtual straight line L3 extending from the second output coordinate point d and passing through the marked position A is drawn on the coordinate plane. Then, a coordinate position that is on the virtual straight line L3 and that is moved from the second output coordinate point d toward the marked position A by the distance corresponding to the radius R is marked (set a marked position B).

The second step ST8 mentioned above is repeatedly performed alternately between the first output coordinate point c and the second output coordinate point d, so that the most recently set marked position is sequentially updated to a new marked position. That is, the next virtual straight line extending from the first output coordinate point c and passing through the marked position B is drawn on the coordinate plane, and a coordinate position that is on the virtual straight line and that is moved from the first output coordinate point c toward the marked position B by the distance corresponding to the radius R is marked (set a marked position C). Subsequently, the next virtual straight line extending from the second output coordinate point d and passing through the marked position C is drawn on the coordinate plane, and a coordinate position that is on the virtual straight line and that is moved from the second output coordinate point d toward the marked position C by the distance corresponding to the radius R is marked (set a marked position D).

By repeatedly performing the second step ST8 mentioned above alternately between the first output coordinate point c and the second output coordinate point d, a marked position finally reaches a convergent point Og3. As third step ST9, the convergent point Og3 is set as a new reference point of an output of the magnetic sensor. The distance between the convergent point (reference point) Og3 and the first output coordinate point c and the distance between the convergent point (convergent point) Og3 and the second output coordinate point d are each equal to the radius R.

In the third step ST9, when a marked position falls within a specific range, it may be determined that convergence has been achieved and defining of a convergent point may be done. For example, when the distance between the first output coordinate point c and a marked position and the distance between the second output coordinate point d and the marked position each fall within a range between the radius R and the radius R + α, the marked position can be defined as a convergent point.

By performing the second correction step ST6 illustrated in Figs. 5 and 7, a minor offset error can be corrected highly accurately.

As illustrated in Fig. 3, in the case of a three-dimensional space, at least three different output coordinate points f, g, and h are required for performing the second correction step ST6. After the first step ST7 of the second correction step ST6 illustrated in Fig. 7 is performed between the first output coordinate point f and the reference point Og to set a marked position A, the second step ST8 for sequentially updating the most recently marked position to a new marked position is repeatedly performed for the second output coordinate point g → the third output coordinate point h → the first output coordinate point f → the second output coordinate point g → the third output coordinate point h → ··· in that order, so that a convergent point can be derived in the three-dimensional space.

In this embodiment, operation processing for both the correction of a major offset error and the correction of a minor offset error can be performed using the radius R (the magnitude of a geomagnetic vector) of a virtual circle or a virtual sphere obtained by calibration, and the offset error can be corrected appropriately and easily with a small amount of operation. Thus, the burden to the controller 10 can be reduced.

In this embodiment, in the case of a larger offset error, the first correction step ST2 explained with reference to Fig. 5 is performed, so that the reference point Og2 is dynamically changed. After that, according to need, that is, in the case where the determination in step ST4 illustrated in Fig. 6 is "Yes", the extraction step ST5 for extracting a plurality of output coordinate points and the second correction step ST6 are performed.

The geomagnetic sensing device 1 according to this embodiment may be used as a geomagnetic gyro. In this embodiment, after calibration, an offset error can be appropriately corrected, and the accuracy in measuring the angular velocity can be improved. Alternatively, the geomagnetic sensing device 1 according to this embodiment may be used as an azimuth indicator, and the azimuth accuracy can be improved.

The geomagnetic sensing device 1 according to the present invention may be used for a portable device such as a cellular phone, a game machine, a robot, and the like. Reference Signs List
- 1: geomagnetic sensing device
- 2: magnetic sensor
- 3: X-axis magnetic sensor
- 4: Y-axis magnetic sensor
- 5: Z-axis magnetic sensor
- 10: controller
- 10a: calibration unit
- 10b: offset error correcting unit
- 10c: operation unit
- 20, 21: virtual circle
- A, B, C, D: marked position
- a-e: output coordinate point
- L1-L3: virtual straight line
- Og, Og1, Og2: reference point
- Og3: convergent point
- R: radius

## Claims

1. A geomagnetic sensing device (1) comprising:
a magnetic sensor (2) having two or more axes (x,y,z) and being configured for providing coordinate point outputs; and
a controller (10);
**characterized by** said controller (10) including
calibration means (10a) configured for calculating the center (Og) and the radius (R) of a virtual circle (20) or a virtual sphere calculated from coordinate point outputs, which are collected while the geomagnetic sensing device (1) is moved at random, and for defining the center (Og) of said sphere as a reference point (Og) of an output of the magnetic sensor (2); said radius (R) being defined by the magnitude of the geomagnetic vector, and
correcting means (10b) for correcting an offset error configured for performing:
an extraction step of extracting a plurality of output coordinate points (a-e) that are deviated from an outer edge of the virtual circle (20) or an outer edge of the virtual sphere and that are located at coordinate positions different from each other,
a first step of marking a coordinate position (A) that is on a virtual straight line (L2) extending from a first output coordinate point (c) and passing through the reference point (Og) and that is moved from the first output coordinate point (c) toward the reference point (Og) by a distance corresponding to the radius R,
a second step of newly marking a coordinate position (B) that is moved on a virtual straight line (L3) extending from a second output coordinate point (d) and passing through the marked position (A) obtained in the first step from the second output coordinate point (d) toward the marked position (A) by the distance corresponding to the radius R,
a third step of newly marking a coordinate position (C) that is moved on a virtual straight line extending from the first output coordinate point (c) and passing through the marked position (B) obtained in the previous step from the first output coordinate point (c) toward the previously marked position (B) by the distance corresponding to the radius R,
a fourth step of newly marking a coordinate position (D) that is moved on a virtual straight line extending from the second output coordinate point (d) and passing through the marked position (C) obtained in the previous step from the second output coordinate point (d) toward the previously marked position (C) by the distance corresponding to the radius R, and
a fifth step of repeatedly performing the third and fourth steps for sequentially updating the most recently set marked position to a new marked position alternately between the individual output coordinate points in order and setting the new marked position as a new convergent point (Og3) of an output of the magnetic sensor (2), when the distance between the first output coordinate point (c) and the new marked position and the distance between the second output coordinate point (d) and the new marked position each fall within a predetermined range.

2. The geomagnetic sensing device (1) according to Claim 1, wherein the magnetic sensor (2) has three axes (x,y,z), in the extraction step, at least three output coordinate points (c,d,e) that are deviated from the outer edge of the virtual sphere having the radius (R) centered at the reference point (Og) and that are located at coordinate positions different from each other are extracted, and the first to fifth steps are performed.

3. The geomagnetic sensing device (1) according to Claim 1, wherein the magnetic sensor (2) has two axes (x,y), in the extraction step, at least two output coordinate points that are deviated from the outer edge of the virtual circle (20) having the radius (R) centered at the reference point (Og) and that are located at coordinate positions different from each other are extracted, and the first to fifth steps are performed.

4. The geomagnetic sensing device (1) according to any one of Claims 1 to 3, wherein in a case where an output coordinate point (a) is deviated further outward than the outer edge of the virtual circle (20) or the virtual sphere having the radius (R) centered at the reference point (Ogl) and is located at a coordinate position that is distant from the reference point (Og1) by a specific number of times or more the length of the radius R, the correcting means (10b) includes, prior to the extraction step, a first correction step of drawing a virtual straight line (L1) between the coordinate point (a) and the reference point (Og1) and setting a coordinate position that is moved from the output coordinate point (a) toward the reference point (Og1) by the distance corresponding to the radius (R) as a new reference point (Og2).

## Patentansprüche

1. Eine geomagnetische Detektionsvorrichtung (1) aufweisend:
einen Magnetsensor (2) mit zwei oder mehr Achsen (x, y, z), der eingerichtet ist, Koordinatenpunkt-Ausgabewerte zur Verfügung zu stellen; und
eine Steuervorrichtung (10) **dadurch gekennzeichnet, dass** die Steuervorrichtung (10) enthält:
Kalibrierungsmittel (10a), die eingerichtet sind, das Zentrum (Og) und den Radius eines virtuellen Kreises (20) oder einer virtuellen Kugel, der/die aus den Koordinatenpunkt-Ausgabewerten berechnet worden ist, die gesammelt werden, während die geomagnetische Detektionsvorrichtung (1) zufällig bewegt wird, zu berechnen, und das Zentrus (Og) dieser Kugel als Referenzpunkt (Og) einer Ausgabe des Magnetsensors (2) zu definieren, wobei der Radius (R) durch die Größe des geomagnetischen Vektors definiert ist;
Korrekturmittel (10b) zum Korrigieren eines Versatz- bzw. Offset-Fehlers, die eingerichtet sind, auszuführen:
einen Extraktionsschritt des Extrahierens mehrerer Ausgabekoordinatenpunkte (a-e), die von einem äußeren Rand des virtuellen Kreises (20) oder einem äußeren Rand der virtuellen Kugel abgeleitet werden, und die an Koordinatenpositionen angeordnet sind, die sich voneinander unterscheiden,
einen ersten Schritt des Markierens einer Koordinatenposition (A), die sich auf einer virtuellen geraden Linie (L2), die sich von einem ersten Ausgabekoordinatenpunkt (c) ausgehend erstreckt, befindet, und die durch den Referenzpunkt (Og) verläuft, und die um einen Abstand, der dem Radius (R) entspricht, vom ersten Ausgabekoordinatenpunkt (c) in Richtung des Referenzpunktes (Og) verschoben ist,
einen zweiten Schritt des erneuten Markierens einer Koordinatenposition (B), die auf einer virtuellen geraden Linie (L3), die sich von einem zweiten Ausgabekoordinatenpunkt (g) ausgehend erstreckt und die durch die markierte Position (A) verläuft, die im ersten Schritt erhalten worden ist, um den Abstand, der dem Radius (R) entspricht, von dem zweiten Ausgabekoordinatenpunkt (d) in Richtung der markierten Position (A) verschoben worden ist,
einen dritten Schritt des erneuten Markierens einer Koordinatenposition (C), die auf einer virtuellen geraden Linie, die sich vom ersten Ausgabekoordinatenpunkt (c) ausgehend erstreckt und die durch die markierte Position (B) verläuft, die im vorherigen Schritt erhalten worden ist, vom ersten Ausgabekoordinatenpunkt (c) um einen Abstand, der dem Radius (R) entspricht, in Richtung der zuvor markierten Position (B) verschoben worden ist,
einen vierten Schritt des erneuten Markierens einer Koordinatenposition (D), die auf einer virtuellen geraden Linie, die sich vom zweiten Ausgabekoordinatenpunkt (d) ausgehend erstreckt und die durch die markierte Position (C) verläuft, der im vorherigen Schritt erhalten worden ist, vom zweiten Ausgabekoordinatenpunkt (d) um einen Abstand, der dem Radius (R) entspricht, in Richtung der zuvor markierten Position (C) verschoben ist, und
einen fünften Schritt des wiederholten Durchführens des dritten und vierten Schritts, um die zuletzt festgelegte Position wiederholt auf eine neue markierte Position zu aktualisieren, abwechselnd zwischen den einzelnen Ausgabekoordinatenpunkten in der Reihenfolge und Festlegen einer neuen markierten Position als einen neuen Konvergenzpunkt (Og3) eines Ausgabewertes des Magnetsensors (2), wenn sich der Abstand zwischen dem ersten Ausgabekoordinatenpunkt (c) und der neu markierten Position und der Abstand zwischen dem zweiten Ausgabekoordinatenpunkt (d) und der neuen markierten Position beide innerhalb eines vorgegebenen Bereichs befinden.

2. Die geomagnetische Detektionsvorrichtung (1) nach Anspruch 1, wobei der Magnetsensor (2) drei Achsen (x, y, z) hat und im Extraktionsschritt wenigstens drei Ausgabekoordinatenpunkte (c, d, e) extrahiert werden, die vom äußeren Rand der virtuellen Kugel mit einem Radius (R), die im Referenzpunkt (Og) zentriert ist, abweichen, und die an voneinander abweichenden Positionen angeordnet sind, und der erste bis fünfte Schritt durchgeführt werden.

3. Die geomagnetische Detektionsvorrichtung (1) nach Anspruch 1, wobei der Magnetsensor (2) zwei Achsen (x, y) hat, und im Extraktionsschritt wenigstens zwei Ausgabekoordinatenpunkte extrahiert werden, die vom äußeren Rand des virtuellen Kreises (20) mit dem Radius (R), der am Referenzpunkt (Og) zentriert ist, abweichen, und die an voneinander verschiedenen Koordinatenpositionen angeordnet sind, und der erste bis fünfte Schritt durchgeführt werden.

4. Die geomagnetische Erkennungs-Vorrichtung nach einem der Ansprüche 1 bis 3, wobei in einem Fall, in dem ein Ausgabekoordinatenpunkt (a) weiter als der äußere Rand des virtuellen Kreises (20) oder der virtuellen Kugel mit dem Radius (R) der/die am Referenzpunkt (Og1) zentriert ist, nach außen abweicht, und sich an einer Koordinatenposition befindet, die vom Referenzpunkt (Og) um ein vorgegebenes Vielfaches oder mehr der Länge des Radius (R) beabstandet ist, das Korrekturmittel (10b) vor dem Extraktionsschritt einen ersten Korrekturschritt des Ziehens einer virtuellen geraden Linie (L1) zwischen dem Koordinatenpunkt (a) und dem Referenzpunkt (Og1) und des Festlegens einer Koordinatenposition, die vom Ausgabekoordinatenpunkt (a) um den Abstand, der dem Radius (R) entspricht, in Richtung des Referenzpunktes (Og1) verschoben ist, als neuen Referenzpunkt (Og2) umfasst.

## Revendications

1. Dispositif de détection géomagnétique (1) comprenant :
un capteur magnétique (2) ayant deux axes ou plus (x,y,z) et étant configuré pour fournir des sorties de points de coordonnées ; et
un contrôleur (10) ;
**caractérisé en ce que** ledit contrôleur comprend :
un moyen d'étalonnage (10a) configuré pour calculer le centre (Og) et le rayon (R) d'un cercle virtuel (20) ou d'une sphère virtuelle calculés à partir de sorties de points de coordonnées, qui sont collectées pendant que le dispositif de détection géomagnétique (1) est déplacé au hasard, et pour définir le centre (Og) de ladite sphère comme point de référence (Og) d'une sortie du capteur magnétique (2), ledit rayon (R) étant défini par l'amplitude du vecteur géomagnétique, et
un moyen de correction (10b) pour corriger une erreur de décalage, configuré pour exécuter :
une étape d'extraction consistant à extraire une pluralité de points de coordonnées de sortie (a-e) qui sont déviés d'un bord extérieur du cercle virtuel (20) ou d'un bord extérieur de la sphère virtuelle et qui sont situés en des positions de coordonnées différentes les unes des autres,
une première étape consistant à marquer une position de coordonnée (A) qui se trouve sur une ligne droite virtuelle (L2) s'étendant depuis un premier point de coordonnée de sortie (c) et passant par le point de référence (Og) et que l'on déplace du premier point de coordonnée de sortie (c) vers le point de référence (Og) sur une distance qui correspond au rayon R,
une deuxième étape consistant à marquer de façon nouvelle une position de coordonnée (B) que l'on déplace sur une ligne droite virtuelle (L3) s'étendant depuis un deuxième point de coordonnée de sortie (d) et passant par la position marquée (A) obtenue dans la première étape du deuxième point de coordonnée de sortie (d) vers la position marquée (A) sur la distance correspondant au rayon R,
une troisième étape consistant à marquer de façon nouvelle une position de coordonnée (C) que l'on déplace sur une ligne droite virtuelle s'étendant depuis le premier point de coordonnée de sortie (c) et passant par la position marquée (B) obtenue à l'étape précédente du premier point de coordonnée de sortie (c) vers la position marquée précédemment (B) sur la distance correspondant au rayon R,
une quatrième étape consistant à marquer de façon nouvelle une position de coordonnée (D) que l'on déplace sur une ligne droite virtuelle s'étendant depuis le deuxième point de coordonnée de sortie (d) et passant par la position marquée (C) obtenue à l'étape précédente du deuxième point de coordonnée de sortie (d) vers la position marquée précédemment (C) sur la distance correspondant au rayon R, et
une cinquième étape consistant à exécuter de manière répétée les troisième et quatrième étapes pour actualiser de façon séquentielle la position marquée établie le plus récemment avec une nouvelle position marquée alternativement entre les points de coordonnées de sortie individuels dans l'ordre et établir la nouvelle position marquée à un nouveau point convergent (Og3) d'une sortie du capteur magnétique (2), quand la distance qui sépare le premier point de coordonnée de sortie (c) de la nouvelle position marquée et la distance qui sépare le deuxième point de coordonnée de sortie (d) de la nouvelle position marquée sont toutes les deux dans une plage prédéterminée.

2. Dispositif de détection géomagnétique (1) selon la revendication 1, dans lequel le capteur magnétique (2) a trois axes (x,y,z), dans l'étape d'extraction, on extrait au moins trois points de coordonnées de sortie (c,d,e) qui sont déviés du bord extérieur de la sphère virtuelle ayant le rayon (R) centré au point de référence (Og) et qui sont situés en des positions de coordonnées différentes les unes des autres, et l'on exécute les cinq premières étapes.

3. Dispositif de détection géomagnétique (1) selon la revendication 1, dans lequel le capteur magnétique (2) a deux axes (x,y), dans l'étape d'extraction, on extrait au moins deux points de coordonnées de sortie qui sont déviés du bord extérieur du cercle virtuel(20) ayant le rayon (R) centré au point de référence (Og) et qui sont situés en des positions de coordonnées différentes les unes des autres, et l'on exécute les cinq premières étapes.

4. Dispositif de détection géomagnétique (1) selon l'une quelconque des revendications 1 à 3, dans lequel, dans le cas où un point de coordonnée de sortie (a) est dévié plus à l'extérieur que le bord extérieur du cercle virtuel (20) ou de la sphère virtuelle ayant le rayon (R) centré au point de référence (Og1) et est situé en une position de coordonnée qui est distante du point de référence (Og1) d'un nombre spécifique de fois ou plus la longueur du rayon R, le moyen de correction (10b) comprend, avant l'étape d'extraction, une première étape de correction consistant à tracer une ligne droite virtuelle (L1) entre le point de coordonnée (a) et le point de référence (Og1) et à établir une position de coordonnée que l'on déplace du point de coordonnée de sortie (a) vers le point de référence (Og1) sur la distance correspondant au rayon (R) en tant que nouveau point de référence (Og2).
